# EUROPEAN PATENT APPLICATION

(11) **EP 2 213 415 A1**
(43) Date of publication of application: **04.08.2010**
(21) Application number: 09290064.6
(22) Date of filing: 29.01.2009
(51) Int. Cl.: B24B 9/06, B24B 37/04, H01L 21/304

(54) **Device for polishing the edge of a semiconductor substrate**

(71) Applicant: S.O.I. TEC Silicon, 38190 Bernin (FR)
(72) Inventor: Kerdiles, Sèbastien, 38330 Saint Ismier (FR); Schwarzenbach, Walter, 38330 Saint Nazaire Les Eymes (FR); Alami-Idrissi, Aziz, 38660 Le Touvet (FR)
(74) Representative: Grünecker, Kinkeldey, Stockmair & Schwanhäusser Anwaltssozietät

(57) **Abstract**

The invention relates to a device for chemical and mechanical polishing of the edge of a semiconductor substrate comprising a protruding residual topography in a peripheral region of the substrate resulting from a layer transfer process based on an ion implantation step, a bonding step and a detachment step, such as Smart-Cut^{™}. To be able to remove this step-like region, the device comprises a polishing pad, wherein the polishing pad is arranged and configured such that its cross section in a plane perpendicular to the surface of a substrate holder is curved. The invention furthermore relates to a pad holder used in the device and a method for polishing a semiconductor substrate comprising a protruding residual topography.

## Description

The invention relates to a device for polishing of the edge of a semiconductor substrate comprising a protruding residual topography in a peripheral region of the substrate resulting from a layer transfer comprising an ion implantation step, a polishing pad used in such a device and a method for reclaiming a surface of a semiconductor substrate comprising a protruding residual topography.

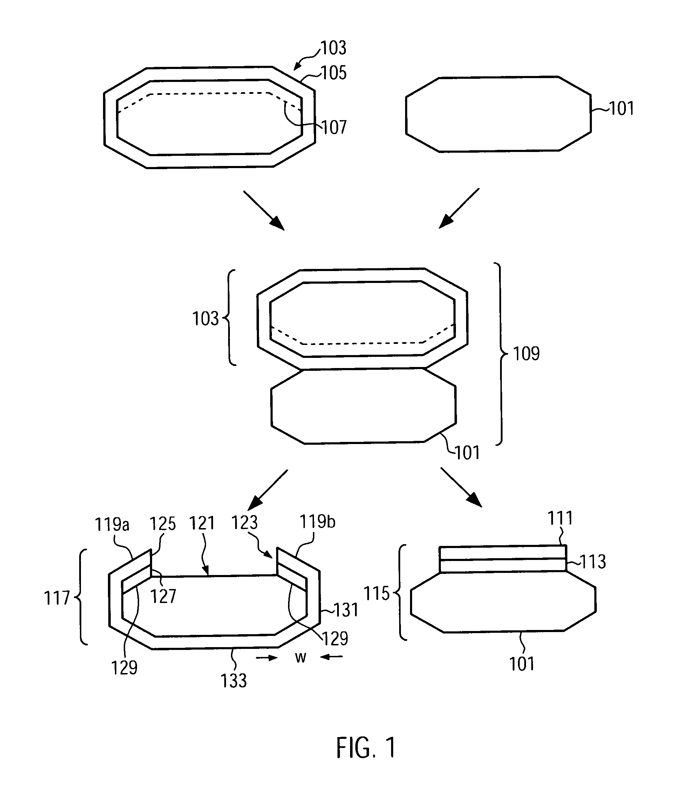

The so-called Smart Cut^{™} process, illustrated in Figure 1 provides high quality silicon on insulator (SOI) substrates. During this process, two substrates, called a handle substrate 101 and a donor substrate 103, usually a silicon wafer, undergo a certain number of process steps to transfer a layer with a given thickness of the donor substrate 103 onto the handle substrate 101. During the process, an oxide layer 105 is typically generated (e.g. by thermal oxidation or by deposition of an oxide) on the donor substrate 103 to later on form the buried oxide layer (BOX) of the SOI structure, and an ion implantation step is applied to form a predetermined splitting area 107 defining the to-be-transferred layer. Subsequently, the source substrate 103 is attached to the handle substrate 101, in particular via bonding, taking advantage of Van der Waal's forces, to obtain a source-handle compound 109. Upon a mechanical and/or thermal treatment, a detachment of a semiconductor layer 111 together with the buried oxide layer 113 occurs at the predetermined splitting area 107 so that the two layers are transferred onto the handle substrate 101 to obtain the desired silicon on insulator structure 115.

The remaining part 117 of the donor substrate 101, also called the negative, can be recycled and again used in the Smart Cut^{™} type process as a new donor or handle substrate. The Smart Cut^{™} type SOI fabrication process has a significant economic advantage due to the recycling process. Indeed, the process provides an optimized use of the raw material for instance silicon wafers.

The negative has a characteristic topography representing protruding residues 119a and 119b in an edge region, as illustrated in Figure 1, which corresponds to a region where no layer transfer occurred due to the shape of the edge of the initial wafers 103 and/or 101.

The protruding regions 119a and 119b actually belong to one essentially ring-shaped residue seen in cross-section. The surface of the negative 117 between the protruding residues 119a and 119b has a first inner region 121 at which detachment occurred to provide the transferred layer 111 on the handle substrate 109 and which has a rather rough surface, with roughness values close to 60 - 70 Å RMS as measured by AFM, to be compared to 1 - 3 Å for standard Silicon wafer. The edge of the remainder 117 with the protruding residues 119a and 119b actually has a chamfered shape and furthermore comprises a step-like structure 123 seen from the internal region 121 comprising the remaining part of the buried oxide layer 125 and the non-transferred silicon 127 over the remaining part of the ion implanted predetermined splitting area 129. The edge 131 and the backside 133 of the negative 117 are, by the way, also covered by the oxide.

The step 123 of the negative 117 typically has a thickness of about 1.000-10.000 Å of silicon and 100-10.000 Å of silicon oxide and has a width w in the lateral direction of the order of 1 - 2 mm.

The protruding residual topography 119a and 119b needs to be removed prior to the reuse of the negative 117 as donor substrate 103 or handle substrate 101. Methods to do so are, for example, known from EP 1 156 531 A1 and US 7,402,520 B2. Typically, the following process is applied to get rid of the protruding residual topography: The reclaiming process starts with a de-oxidation step to remove the oxide layer 125 on top of the protruding residual topography on the edge of the remainder 117 as well as on the side 131 and on its backside 133. The de-oxidation can, for example, be carried out using a HF bath, wherein the acid consumes the oxide layer 125, 131 and 133. Subsequently, a first polishing step of the edge region of substrate 1 is carried out to at least partially remove the protruding silicon part 127 and implantation residue. Then a double-sided polishing (DSP) step is carried out to improve the surface roughness in the interior region 121 but also to further remove the step 123 in the direction of the protruding residual topography 119a and 119b. During the DSP process about 10 µm (5 µm on each side of the substrate) of the substrate are removed. Finally, to obtain a suitable surface roughness on the front surface of the remainder 117, a chemical mechanical polishing step (CMP) is carried out.

The removal of the protruding silicon parts 119a an 119b actually cannot be carried out with a CMP process, as for such a high material removal the geometry of the reclaimed substrate degrades. Using DSP, the desired geometric properties can be kept because wafers undergo floating polishing. Indeed, in the case of DSP the wafer is floating between two polishing pads, whereas in case of CMP the wafer is fixed to a support on the backside which may induce mechanical constraints during polishing and thus lead to a degraded planarity.

It is the objection of the invention to provide an improved reclaiming process and a device to carry out this improved reclaiming process so that the double-sided polishing step with its extensive material removal becomes obsolete.

This object is achieved with the device for polishing the edge of a semiconductor substrate comprising a protruding residual topography in a peripheral region of the substrate resulting from transfer process based on an ion implantation step, a bonding step and a detachment step , in particular according to a Smart-Cut^{™} type process The device according to the invention comprises a substrate holder for receiving the semiconductor substrate, and a polishing pad, wherein the polishing pad is arranged and configured such that its cross section in a plane perpendicular to the surface of the substrate holder is curved.

The curved cross section has the advantage that the protruding residual topography can be removed over its entire radial extent so that a double side polishing step, like used in the prior art, is no longer necessary. This has the particular advantage that due to the use of the device according to the invention, a polishing process that consumes less material compared to the known process applying DSP can be carried out. At the same time, polishing using a curved pad has the further advantage that the cross section can be chosen such that the geometry of the substrate, in particular in the edge region, can be kept constant meaning that, in case the substrate is reused, the quality of the products achieved out of recycled substrate remains stable. As a consequence the reclaiming process can be carried out faster and at less cost.

Indeed, as the cross section of the polishing pad is curved in a plane perpendicular to the surface of the substrate holder, it is also curved with respect to the surface of the substrate positioned on the substrate holder. In this context, the curved surface is arranged towards the substrate holder, thus facing a substrate when positioned on the substrate holder. In a preferred embodiment, the plane perpendicular to the surface of the substrate holder is defined by the normal to the substrate holder and, thus, the normal of a substrate positioned on the substrate holder and the radial direction of said substrate positioned on the substrate holder.

Preferably, the polishing pad can be attached to a pad holder which is arranged and configured such that its cross section in the plane perpendicular to the surface of the substrate holder is curved. By providing the curved pad holder, any suitable, e.g. flexible, polishing pad can be adapted such that its polishing side is curved according to the invention.

According to a preferred embodiment, the cross section of the polishing pad and/or the pad holder can comprise a concave shaped part. Thus, the polishing pad or the pad holder has a surface that is curved inward on the side facing the substrate holder. In this context, it is further preferred that the concave shape corresponds to the desired final shape of the semiconductor substrate, in particular to a final shape with an edge region without protruding topography and that keeps the original geometry of the substrate, thus with chamfered edge region. This particular shape has the advantage that the protruding part, typically corresponding to a step-like corona at the peripheral edge of the substrate, can be completely removed in one step and even with only one translational movement in one direction (vertical or oblique), and which can be carried out by either the pad/the holder or the substrate holder, Thus, in only one step, which in addition is technically easy to realize, the unwanted protruding region can be removed while, at the same time, the original geometry of the substrate can be kept. The concave shape can be achieved by a continuous curvature or a succession of straight lines.

According to a preferred embodiment, the cross section of the polishing pad and/or the pad holder can have at least one convex shaped part. The convex shape has the advantage that a local polishing can be carried out. Thus, by programming the movement of the polishing pad/polishing holder over the surface of the substrate to be polished, the step-like protruding topography can also be completely removed. Eventually, when using this kind of polishing pad, an additional edge polishing step can be applied, using for example an edge-polishing technique controlled horizontally (or radially) and polishing the outer part of the peripheral region and the side of the substrate. This way, the remaining implanted layer on the chamfered edge of the wafer, can be also removed.

According to a preferred variant of the invention, the cross section of the polishing pad and/or the pad holder can have its concave shaped part positioned between two convex shaped parts. In this embodiment of the invention, the concave part of the polishing pad or pad holder has a shape corresponding to the desired final shape of the edge region of the substrate. The convex part provides a smooth transition between the step like part of the protruding portion and the interior surface of the substrate where detachment occurred. The relative movement between polishing pad/pad holder and substrate/substrate holder also only needs to be in one direction (vertical / oblique).

According to a variant, the cross section of the polishing pad and/or the pad holder can have at least one plane part positioned between convex and/or concave shaped parts. Such a polishing pad/pad holder is easy to realize and allows an effective removal of the step part of the protruding topography, thus the part which is positioned above the surface at which detachment occurs. The lateral extension of the plane part is adapted to the lateral width of the residue. For the chamfered edge part, an additional edge polishing can be carried out to also polish the edge region of the substrate.

Preferably, the lateral extension of the polishing pad and/or pad holder can be at least 1.5 mm, preferably at least 3 mm, notably in case of wafers with 300mm diameter. In this context, the lateral extension relates to the extension of the polishing pad/pad holder which comes into contact with the substrate to be polished in the radial direction of the substrate. By providing an extension of at least 1.5 mm, the entire edge region on the circumference of the substrate with protruding parts can be removed. By furthermore providing an extension of at least 3 mm, it furthermore becomes possible to remove any protruding part in the notch region of a semiconductor wafer, indicating the crystalline direction of the substrate. Thus in one run it becomes possible to effectively polish the circumferential edge region and the notch region to remove the protruding parts. This therefore further optimizes the process.

According to a preferred embodiment, the polishing pad and/or the pad holder can be ring-shaped at least over a segment in the plane parallel to the surface of the substrate holder. By extending the polishing pad and/or the pad holder over large angular range in the plane parallel to the substrate surface, a large polishing interacting surface can be provided so that the polishing process can be carried out quickly. In this context, a complete ring is in particular preferred with shapes of the polishing pad/pad holder which are such that a simple vertical translation between the pad holder and the substrate is sufficient to get rid of the protruding region.

Advantageously, the polishing pad and/or the pad holder can be formed by a plurality of segments. By providing a plurality of segments instead of one ring, the desired large polishing surface can be achieved in a simple manner.

Preferably, the device can furthermore comprise a control unit configured to move the polishing pad and/or the pad holder perpendicular with respect to the surface of the substrate holder. Depending on the form of the curved surface, it is thus sufficient to provide only one translation to be able to remove the entire residual protruding topography in the edge region of the substrate.

According to a preferred embodiment, the control unit can also be configured to move the polishing pad and/or the pad holder in a plane parallel to the surface of the substrate holder. In case of the concave or convex plane pad holder/polishing pad, still the entire edge region, thus the protruding part and the chamfered region, can be polished.

The invention also relates to a pad holder for use in a device according to the above-described features, wherein the surface is configured to receive a polishing pad having a curved surface. With this pad holder, the advantages as described above with respect to the device can be achieved.

The invention is also achieved with a method according to claim 14, thus a method for reclaiming a surface of a semiconductor substrate comprising a protruding residual topography in a peripheral region of the substrate resulting from an ion implantation and layer transfer process, comprising the steps of: polishing the surface using a device as described above. With this method, it thus becomes possible to reclaim a semiconductor substrate without having to carry out the double-sided polishing like in the prior art so that the substrate can be reused more often in a Smart Cut^{™} type layer transferring process.

Preferably, the method can be carried out such that more than the protruding parts of the topography are removed during polishing, in particular, the edge parts on the side of the substrate, in particular in the chamfered region.

Further preferred, the method can comprise a de-oxidation step to remove any oxide present on the protruding topography. This further facilitates the polishing process.

Advantageously, the method can further comprise an edge polishing step. Depending on the shape of the polishing pad/pad holder, the edge polishing step can be used to remove undesired material on the edge/side of the substrate. The described polishing method is essentially a mechanical polishing but can nevertheless also be carried out as a chemical mechanical polishing

Advantageous embodiments of the invention will now be described in relation to the enclosed Figures:
Figure 1 illustrates a Smart Cut^{™} type transfer process leading to the remainder of a donor substrate comprising a protruding residual topography,
Figure 2 illustrates a first embodiment of a device for polishing the edge of a semiconductor substrate,
Figure 3 illustrates the cross sectional view of a first polishing pad according to the invention,
Figure 4 illustrates the cross sectional view of a second polishing pad according to the invention,
Figure 5 illustrates the cross sectional view of a third polishing pad according to the invention,
Figure 6 illustrates the cross sectional view of a fourth polishing pad according to the invention, and
Figures 7a and 7b illustrate a top view of a polishing pad according to the invention.

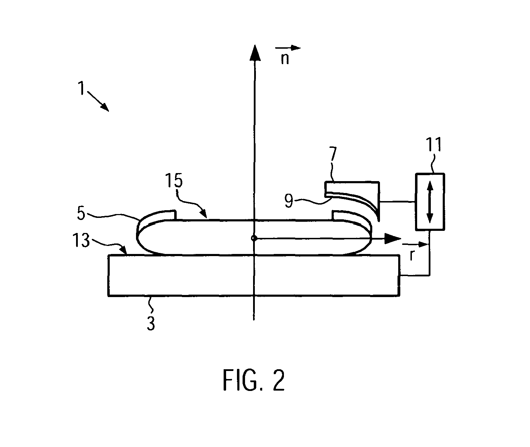

Figure 2 schematically illustrates a cross cut view of a device 1 for polishing the edge of a semiconductor substrate according to the invention. The device 1 comprises a substrate holder 3 which is configured for receiving a semiconductor substrate 5, which does not belong to the device 1, and a pad holder 7 with a polishing pad 9 facing the semiconductor substrate 5, attached to it. The device 1 for polishing furthermore comprises a control unit 11 configured to allow a relative movement between the pad holder 7 and the substrate holder 3. This relative movement is preferably in the vertical direction, like indicated in the figure, but according to variants could follow other directions as the one indicated in Fig. 2. The substrate 5 corresponds to the negative 117 illustrated in Figure 1.

As illustrated in Figure 2, the cross section of the pad holder 7, and as a consequence also of the polishing pad 9, has a curved shape in the plane of the drawing. The drawing plane is perpendicular to the surface 13 of the substrate holder 3 which receives the semiconductor substrate 5. The drawing plane is thus also a plane that is perpendicular to the surface 15 of substrate 5 where, as explained in the introductory part, detachment occurred. The cross section illustrated in Figure 2 furthermore corresponds to the plane which not only comprises the normal n of the substrate holder surface 13 and the surface 15 of substrate 5, but also a radial direction r with respect to the centre of substrate 5 positioned on the substrate holder 3.

In Figure 2, the pad holder 7 is illustrated in combination with a distinct polishing pad 9, nevertheless both elements could also be made out of one single work piece instead. To carry out the polishing, the polishing pad 9/pad holder 7 and/or the substrate holder 3 actually are rotated about axis n, when the pad and substrate are in contact.

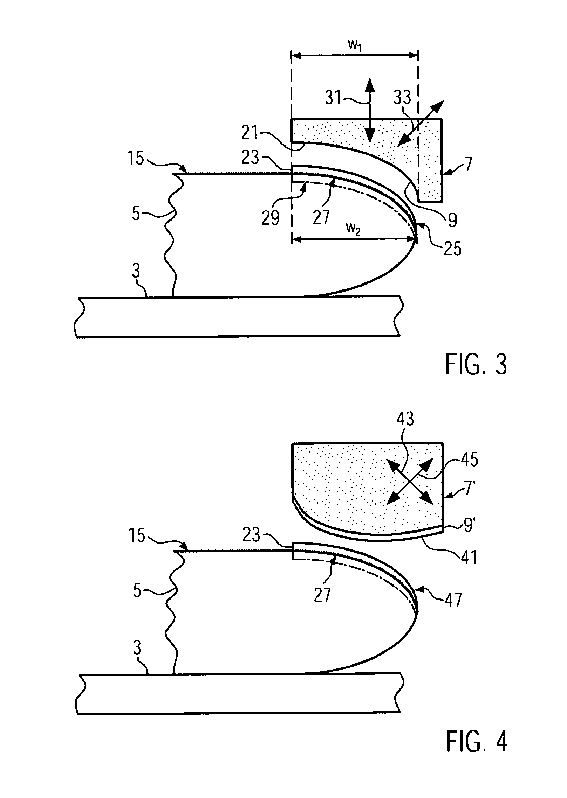

Figure 3 illustrates a first embodiment of pad holder 7 and polishing pad 9 according to the invention. Here both elements are illustrated as one unit. The cross sectional view illustrated in Figure 3 is the same as the one illustrated in Figure 2.

The cross section of pad holder 7/polishing pad 9 has a concave shaped part 21 facing the substrate 5 positioned on the substrate holder 3. In the lateral direction, thus in the radial direction r in Figure 2 of substrate 5, the pad holder 7/polishing pad 9 has its concave portion 21 extending over at least a width w1 corresponding to the width w2 of the edge portion of substrate 5 that carries the protruding residual topography 23 (see also Figure 1). Typically, the width w2 is of the order of 1.5 mm so that w1 is also of at least 1.5 mm.

According to the variant, the width w1 is chosen to be at least 3 mm. In this case it becomes possible to remove also the protruding topography in the notch region of a semiconductor wafer.

The concave shape 21 of the pad holder 7/polising pad 9 is chosen such that it corresponds to the negative of the desired final shape for the edge region of substrate 5. With the shape of the polishing pad 9, as illustrated in Figure 3, it is thus possible to remove the step 23 and at the same time also the edge region 25. Typically, the control unit 11, illustrated in Figure 2, is programmed such that at least the area in the edge region positioned above the predetermined splitting area defined by the ions implanted as described above in relation to Figure 1 and illustrated with the dotted line 27 in Figure 3, is removed. As the exact end point at which the surface in the edge region corresponds to surface 15 of the substrate 5 at which detachment occurred is rather difficult to achieve, the control unit 11 can be configured such that the polishing goes beyond the level of surface 15 so that a counter step is obtained. This counter step is illustrated by the dot dashed line 29 in Figure 3.

Arrows 31 and 33 illustrate two variants concerning the movement of the pad holder 7/polishing pad 9 with respect to substrate 5 and substrate holder 3 and which is controlled by the control unit 11. To remove the step-like protruding portion 23, either a vertical movement 31 can be carried out to bring the polishing pad 9/pad holder 7 in contact with respect to the surface of substrate 5 or, instead, an oblique movement 33, but still only along one single direction, can be carried out.

In Figure 3 the concave shape is achieved using a continuous curved shape. Instead the concave shape could also be achieved by a succession of straight lines.

Following the removal of the protruding topology, a standard CMP polishing step is carried out to polish the entire surface of substrate 5 to prepare the semiconductor substrate for reuse.

Figure 4 illustrates a second embodiment of the pad holder 7'/polishing pad 9' according to the invention. As in the first embodiment illustrated in Figure 3, it has a curved surface facing the substrate 5 positioned on substrate holder 3. Unlike the first embodiment, the surface of this embodiment has a convex shape 41 in this embodiment. With this pad holder 7'/polishing pad 9', it is possible to locally remove material from the step-like edge region 23 of substrate 5, by moving the pad holder 7'/polishing pad 9' over the surface of the substrate 5, like illustrated by arrows 43 and 45. Nevertheless, using the pad holder 7'/polishing pad 9', the portion in the edge region of substrate 5 which extends above the predetermined splitting area 27 or even beyond to achieve a counter step illustrated by the dot dashed line 29, can be removed by suitably programming control unit 11 so that no DSP polishing is necessary, like in the previous embodiment.

According to a variant, the pad holder 7'/polishing pad 9' could also only be moved in one direction, as illustrated in the embodiment of Figure 3, along the direction of arrow 31 or arrow 33. In this case the step 23 is removed, and an additional edge polishing process step is carried out to remove the unwanted material on the side 47 of substrate 5.

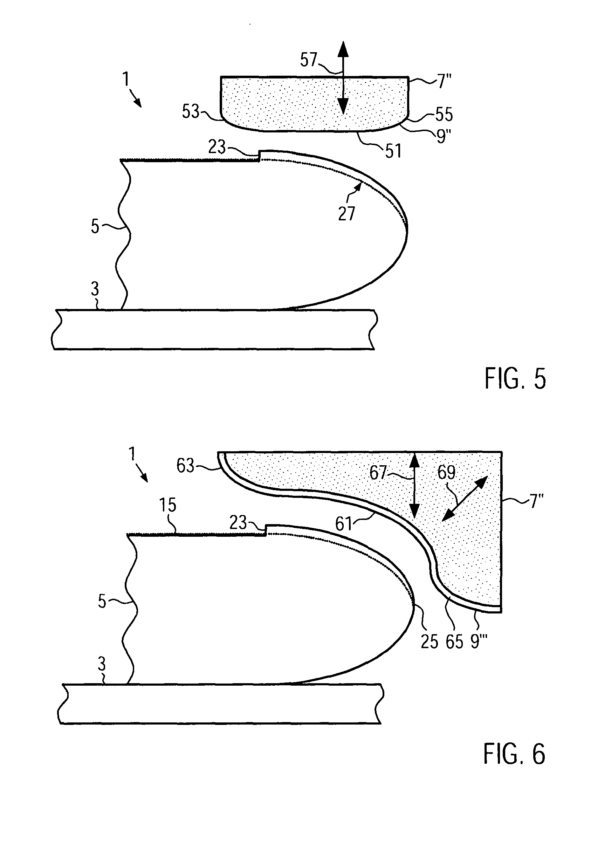

Figure 5 illustrates a third embodiment of the pad holder 7" and polishing pad 9". The shape of the cross section facing the substrate 5 positioned on substrate holder 3 has a plane part 51 positioned between two convex parts 53, 55. This shape is specially adapted to remove the step 23 in the edge region of substrate 5, in particular when it is associated with a vertical movement along arrow 57 controlled by control unit 11, which is illustrated in Figure 2. This embodiment has the advantage that it is easy to realize. It can be associated with an additional edge polishing step to remove the unwanted parts positioned above the predetermined splitting area 27 on the side of substrate 5.

Figure 6 illustrates a fourth embodiment of a pad holder 7"' and polishing pad 9"' which combines a central concave portion 61 and two convex portions 63, 65 and the side facing the surface 15 of the substrate 5. In this embodiment, with one translational direction along arrow 67 or 69, thus along a vertical direction or an oblique direction, the desired final shape of substrate 5 can be achieved with one polishing step, in particular also on the side 25 of substrate 5, so that an additional edge polishing step becomes obsolete. Furthermore, due to the smooth transition between the concave and convex portions, the transition between the area with the step 23 and the area on the surface of substrate 5 without step 15 (where detachment occurred), is also smooth.

All embodiments of the invention have the advantage that the undesired protruding residual topography in the peripheral region of the substrate can be completely removed. As a consequence a double-sided polishing, like in the prior art, is no longer necessary. Thus, the material removal during reclaiming of a substrate can be limited, typically to about 2000 to 12000 Å so that the substrate can be recycled more often compared to a process with double sided polishing and at lower cost.

Thus, the recycling process according to the invention comprises a de-oxidation step, a protruding residual topography polishing step, like described above using the polishing device according to the invention, and eventually an edge polishing step, depending on the pad holder/polishing pad used. The process is terminated by a conventional chemical mechanical polishing step to obtain the desired surface roughness necessary for the reuse of the substrate either as a donor or a handle substrate, like illustrated in Figure 1.

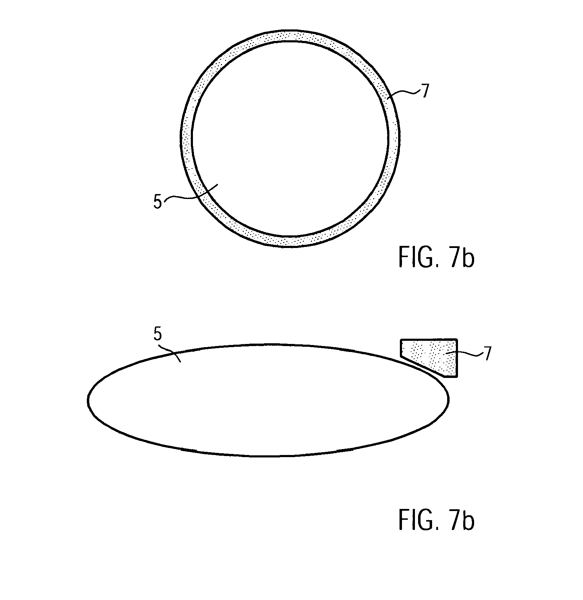

Figures 7a and 7b illustrate a top view of the device for polishing according to the invention illustrated in Figure 2.

Figure 7A shows an embodiment according to the invention in which the pad holder 7 has a ring-shape so that the interaction surface between the polishing pad 7 and the substrate 5 positioned on the substrate holder is maximal. In this case, the geometries of the pad holder 7,7'"/polishing pad 9, 9"' according to the first and fourth embodiments can be used. In this case the control unit 11 provides a vertical movement to bring the pad holder/ polishing pad in contact with the surface of the substrate 5. Instead of a full ring, several segments distributed around the circumference of the substrate/substrate holder can be provided.

Figure 7b illustrates a further variant, which can be applied in case the pad holder has to be moved along two directions, like in the second and third embodiments.

## Claims

1. Device for polishing the edge of a semiconductor substrate comprising a protruding residual topography in a peripheral region of the substrate resulting from a layer transfer process based on an ion implantation step, a bonding step and a detachment step, comprising:
- a substrate holder for receiving the semiconductor substrate, and
- a polishing pad,
wherein the polishing pad is arranged and configured such that its cross-section in a plane perpendicular to the surface of the substrate holder is curved.

2. Device according to claim 1, wherein the polishing pad is attached to a pad holder, which is arranged and configured such that its cross-section in the plane perpendicular to the surface of the substrate holder is curved.

3. Device according to claim 1 or 2, wherein the cross-section of the polishing pad and/or the pad holder comprises a concave shaped part.

4. Device according to claim 3, wherein the concave shape corresponds to the desired shape of the semiconductor substrate, in particular to a shape with an edge region without protruding topography.

5. Device according to one of claims 1 to 4, wherein the cross-section of the polishing pad and/or the pad holder has at least one convex shaped part.

6. Device according to one of claims 3 to 5, wherein the cross section of the polishing pad and/or the pad holder has the concave shaped part positioned between two convex shaped parts.

7. Device according to one of claims 3 to 6, wherein the cross section of the polishing pad and/or the pad holder has at least one plane part positioned between convex and/or concave shaped parts.

8. Device according to one of claims 1 to 7, wherein the lateral extension of the polishing pad and/or pad holder is at least 1.5 mm, preferably at least 3mm.

9. Device according to one of claims 1 to 8, wherein the polishing pad and/or the pad holder is ring shaped at least over a segment in the plane parallel to the surface of the substrate holder.

10. Device according to claim 9, wherein the polishing pad and/or the pad holder are formed by a plurality of segments.

11. Device according to one of claims 1 to 10, further comprising a control unit configured to move the polishing pad and/or the pad holder perpendicular with respect to the surface of the substrate holder.

12. Device according to one of claims 1 to 11, wherein the control unit is configured to move the polishing pad and/or the pad holder in a plane parallel to the surface of the substrate holder.

13. Pad holder for use in a device according to one of claims 1 to 12, wherein the surface configured to receive a polishing pad has a curved surface.

14. Method for reclaiming a surface of a semiconductor substrate comprising a protruding residual topography in a peripheral region of the substrate resulting from a layer transfer process based on an ion implantation step, a bonding step and a delamination step, comprising the steps of:
- polishing the surface using a device according to one of claims 1 to 12,

15. Method according to one of claims 14, wherein more than protruding parts of the topography are removed during polishing.

16. Method according to claim 14 or 15, further comprising a de-oxidation step to remove any oxide present on the protruding topography.

17. Method according to one of claims 14 to 16, further comprising an edge polishing step.
